# EUROPÄISCHE PATENTSCHRIFT

(11) **EP 3 642 964 B1**
(45) Veröffentlichungstag und Bekanntmachung des Hinweises auf die Patenterteilung: **07.07.2021**
(21) Anmeldenummer: 18803355.9
(22) Anmeldetag: 06.11.2018
(51) Int. Cl.: H03F 3/189, H03F 3/24, H04B 1/04, H04B 1/00

(54) **VERFAHREN UND VORRICHTUNGEN ZUR VERSTÄRKUNG VON FUNKSIGNALEN ZWISCHEN EINEM ENDGERÄT UND EINER ANTENNE**
METHOD AND DEVICES FOR AMPLIFYING RADIO SIGNALS BETWEEN A TERMINAL DEVICE AND AN ANTENNA
PROCÉDÉ ET DISPOSITIF D'AMPLIFICATION DE SIGNAUX RADIOÉLECTRIQUES ENTRE UN APPAREIL TERMINAL ET UNE ANTENNE

(30) Priorität: 06.11.2017 DE 102017219686
(43) Veröffentlichungstag der Anmeldung: 29.04.2020
(73) Patentinhaber: MOLEX CVS DABENDORF GMBH, 15806 Zossen (DE)
(72) Erfinder: KAUTGE, Helmut, 14532 Stahnsdorf (DE); LEHMANN, Lars, 15745 Wildau (DE); NAST, Helmut, 12557 Berlin (DE)
(74) Vertreter: Kaufmann, Tobias
(86) Internationale Anmeldenummer: PCT/EP2018/080300
(87) Internationale Veröffentlichungsnummer: WO 2019/086701

(56) Entgegenhaltungen:
- DE-A1-102006 010 963
- DE-A1-102013 000 270

## Beschreibung

### HINTERGRUND DER ERFINDUNG

### Gebiet der Erfindung

Die vorliegende Erfindung betrifft ein Verfahren zur Verstärkung von Funksignalen zwischen einem Endgerät und einer Antenne sowie eine Schaltungsanordnung zum Ausführen eines solchen Verfahrens.

### Beschreibung des Stands der Technik

Hinsichtlich Funksignalen, die von einer in einem Kraftfahrzeug befindlichen Funkvorrichtung wie beispielsweise einem Mobiltelefon, einem Smartphone, einem Steuergerät oder einem Notfallsender (nachfolgend Mobilfunkgerät) gesendet und empfangen werden, wirkt die Karosserie eines Kraftfahrzeugs als *"Faraday'scher Käfig",* das heißt sie schirmt die Funksignale ab. Sende- und Empfangssignale des Mobilfunkgeräts werden dadurch abgeschwächt, wobei unter Umständen sogar die Benutzung des Mobilfunkgeräts im Fahrzeug nicht mehr möglich sein kann.

Daher ist es vorteilhaft, das Mobilfunkgerät bei der Benutzung im Fahrzeug kabelgebunden oder über eine Antennenstruktur an eine externe Antenne des Fahrzeugs anzukoppeln, um einerseits trotz der abschirmenden Wirkung der Fahrzeugkarosserie einen sicheren Betrieb zu ermöglichen und andererseits die beim Betrieb des Mobilfunkgeräts auftretende Strahlung aus dem Innenraum des Fahrzeugs fernzuhalten. Zu diesem Zweck weist eine entsprechende Verstärkervorrichtung mehrere individuell schaltbare Verstärkerpfade zum Verstärken von Funksignalen in verschiedenen Frequenzbändern auf, die üblicherweise für Uplink- und Downlink-Signalübertragungen in Mobilfunksystemen verwendet werden.

Mobile Endgeräte wie zum Beispiel Mobiltelefone oder Smartphones unterstützen in der Regel eine Vielzahl von Kommunikationsstandards, wie beispielsweise Global System for Mobile Communications (GSM), Universal Mobile Telecommunications System (UMTS), Long Term Evolution (LTE) usw., die unterschiedliche Übertragungsverfahren und unterschiedliche Frequenzbereiche verwenden. Um einen zuverlässigen Betrieb bei Verwendung unterschiedlicher Kommunikationsstandards und/oder unterschiedlicher Frequenzbereiche bereitstellen zu können, muss eine Schaltungsanordnung zur Verstärkung von Funksignalen zwischen einem Endgerät und einer Antenne diese unterschiedlichen Standards und/oder Frequenzbereiche unterstützen und insbesondere mehrbandfähig sein. Beispielsweise muss eine solche Schaltungsanordnung für die unterschiedlichen Frequenzbereiche spezifisch angepasste Verstärker bereitstellen. Da ein oder mehrere aktivierte Verstärker für einen Frequenzbereich jedoch den Frequenzbereich eines oder mehrerer anderer Verstärker stören können, ist es üblich, nur den vom Endgerät aktuell genutzten Frequenzbereich zu verstärken. Die Verstärker der aktuell nicht verwendeten Frequenzbereiche sind hingegen in der Regel nicht aktiviert, um ein gegenseitiges Stören zu vermeiden. "Nicht aktiviert" bedeutet dabei beispielsweise, dass die verstärkenden Eigenschaften der Verstärkerpfade der nicht verwendeten Frequenzbereiche verringert sind. Weiterhin ist ein Deaktivieren von Verstärkern der aktuell nicht verwendeten Frequenzbereiche vorteilhaft, um beispielsweise den Leistungsverbrauch der Schaltungsanordnung zu reduzieren.

Es sind mehrbandfähige Schaltungsanordnungen für bidirektionale Verstärkersysteme bekannt, die entweder eine Kombination aus Frequenzduplexverfahren (Frequency Division Duplex, FDD) und Zeitduplexverfahren (Time Division Duplex, TDD) wie z.B. GSM oder ein reines FDD-Verfahren wie z.B. UMTS, CDMA2000, LTE-FDD unterstützen. Eine Übertragung von Funksignalen zwischen einem Endgerät und einer Antenne in Empfangsrichtung (im Folgenden auch RX oder downlink) und Senderichtung (im Folgenden auch TX oder uplink) findet dabei auf unterschiedlichen Trägerfrequenzen statt. Das Vorhandensein eines Uplink-Signals in einem Frequenzband kann unter bestimmten Voraussetzungen eindeutig durch eine Frequenzselektion sowie eine anschließende Signalleistungsdetektion bestimmt werden. Um die erforderlichen minimalen TX-Nutzsignalpegel detektieren zu können und gleichzeitig benachbarte RX-Nutzsignalpegel zu unterdrücken, ist eine entsprechend hohe Filterwirkung der einzelnen Detektorzweige in der Schaltungsanordnung zu gewährleisten. Dies führt insbesondere bei multibandfähigen Verstärkersystemen zu einer Erhöhung der Komplexität der einzusetzenden Filtertechnologien in den einzelnen Detektorzweigen. Insbesondere steigt die Komplexität mit der Anzahl der unterstützten Bänder.

Einen Sonderfall bilden Verfahren nach Übertragungsstandards, bei denen die RX- und TX-Nutzfrequenzbereiche identisch sind. Ein Beispiel für solche Verfahren sind reine TDD-Verfahren wie z.B. LTE-TDD und TD-SCDMA, bei denen ausschließlich TDD verwendet wird und bei denen Funksignale sowohl in Empfangsrichtung (RX) als auch in Senderichtung (TX) zeitversetzt in demselben Frequenzbereich gesendet werden. Da in solchen Verfahren eine frequenzselektive Unterscheidung von TX- und RX-Signalen nicht möglich ist und sich insbesondere der Dynamikbereich der TX- und RX-Leistungspegel überschneidet, können TX- und RX-Signale bei solchen Verfahren nicht in der üblichen Weise unterschieden werden.

Es sind somit verbesserte Verfahren zur Verstärkung von Funksignalen zwischen einem Endgerät und einer Antenne sowie entsprechende Schaltungsanordnungen zum Ausführen eines solchen Verfahrens wünschenswert, die die oben beschriebenen Probleme und Nachteile überwinden. Insbesondere sind entsprechende verbesserte Verfahren und Schaltungsanordnungen wünschenswert, die eine mehrbandfähige Detektion und Verstärkung von Funksignalen in einem bidirektionalen Zeitmultiplexverfahren mit identischem Sende- und Empfangsfrequenzbereich und somit eine Bestimmung der Richtung der Funksignale ermöglichen.

Ferner sind entsprechende verbesserte Verfahren und Schaltungsanordnungen auch für Frequenzmultiplexverfahren wünschenswert, die insbesondere eine verbesserte Signaldetektion in den jeweiligen Sende- und Empfangsfrequenzbändern ermöglichen.

Die DE 10 2006 010963 A1 betrifft eine mehrbandfähige Schaltungsanordnung zum Kompensieren der Dämpfung eines Antennenzuleitungskabels zu einer externen Antenne für ein Mobilfunkgerät.

Die DE 10 2013 000270 A1 betrifft eine Kompensationsverstärkungsschaltung zum Einbau in eine Übertragungsleitung zwischen einem in einem Kraftfahrzeug befindlichen Mobilfunkgerät bzw. einer kraftfahrzeugseitigen Aufnahme für das Mobilfunkgerät einerseits und einer Antenne des Kraftfahrzeugs andererseits und ein Verfahren zum Betrieb einer entsprechenden bidirektionalen Kompensationsverstärkungsschaltung.

### ZUSAMMENFASSUNG DER ERFINDUNG

Die oben beschriebene Aufgabe wird durch die Erfindung gelöst, wie sie in den unabhängigen Ansprüchen definiert ist. Vorteilhafte Ausführungsformen sind in den abhängigen Ansprüchen definiert.

Ausgehend von den oben dargestellten Problemen soll mit der vorliegenden Erfindung ein Verfahren zum Betrieb einer Schaltungsanordnung zur Verstärkung von Funksignalen zwischen einem Endgerät und einer Antenne bereitgestellt werden, wobei die Schaltungsanordnung eine Verstärkungseinheit mit mindestens einem Sendeverstärkerpfad und mindestens einem Empfangsverstärkerpfad aufweist. Das Verfahren umfasst ein Detektieren einer in Senderichtung, aus Sicht des Endgeräts, in einem ersten Frequenzbereich anliegenden Signalleistung zur Bestimmung einer Sendesignalleistung sowie ein Detektieren einer in Empfangsrichtung, aus Sicht des Endgeräts, in einem zweiten Frequenzbereich anliegenden Signalleistung zur Bestimmung einer Empfangssignalleistung. Weiterhin umfasst das Verfahren ein Vergleichen der detektierten Sendesignalleistung mit der detektierten Empfangssignalleistung. Falls die detektierte Sendesignalleistung stärker ist als die detektierte Empfangssignalleistung, erfolgt ein Aktivieren des Sendeverstärkerpfades zur Verstärkung von Sendesignalen in dem ersten Frequenzbereich. Falls die detektierte Empfangssignalleistung stärker ist als die detektierte Sendesignalleistung, erfolgt ein Aktivieren des Empfangsverstärkerpfades zur Verstärkung von Empfangssignalen in dem zweiten Frequenzbereich.

Aktivieren eines Verstärkerpfades bedeutet dabei, dass der Verstärkerpfad so geschaltet wird, dass er die Signale des entsprechenden Bandes verstärken kann. Der jeweilige Sendeverstärker bzw. Empfangsverstärker muss entsprechend stromführend geschaltet sein. Dies bedeutet jedoch nicht, dass der jeweilige Verstärker in anderen Zuständen als "aktiviert" stromlos geschaltet sein muss.

Soweit im Vorliegenden von dem "Vergleichen" der detektierten Sendesignalleistung mit der detektierten Empfangssignalleistung gesprochen wird, ist ein derartiges Vergleichen nicht darauf beschränkt, dass die von den Detektoren erkannten Leistungen unmittelbar verglichen werden. Vielmehr kann dies auch ein Verrechnen der von den Detektoren erkannten Leistungen umfassen, beispielsweise unter Berücksichtigung, dass die Detektoren hinter entsprechenden Verstärkern platziert sind und/oder unter Berücksichtigung von bei der Kalibrierung der Schaltungsanordnung erhaltenen Werten. Werden beispielsweise die von den Detektoren erkannten Leistungen in Form von Gleichspannungssignalen an eine Steuereinheit übermittelt, schließt das erfindungsgemäße Vergleichen auch mit ein, dass die ausgegebenen Gleichspannungssignale, die die von dem Sendesignalleistungs- bzw. Empfangssignalleistungsdetektor erkannten Sende- bzw. Empfangsleistungen repräsentieren, erst mit entsprechenden Korrekturfaktoren verrechnet werden, um schließlich zu bestimmen, ob die detektierte Sendesignalleistung stärker als die detektierte Empfangssignalleistung ist oder nicht.

Das oben beschriebene Verfahren ermöglicht eine Richtungserkennung von Funksignalen in bidirektionalen Verstärkersystemen.

In einer vorteilhaften Ausführungsform wird, falls die detektierte Empfangssignalleistung stärker ist als die detektierte Sendesignalleistung, zusätzlich der entsprechende Sendeverstärkerpfad deaktiviert. Auf diese Weise werden gegenseitige Störungen der Sende- und Empfangsverstärkerpfade vermieden, und der Leistungsverbrauch der Schaltungsanordnung wird reduziert.

Der Fall, dass die detektierte Empfangssignalleistung stärker ist als die detektierte Sendesignalleistung umfasst auch den Fall, dass kein Sendesignal detektiert werden kann. Falls sowohl die detektierte Sendesignalleistung als auch die detektierte Empfangssignalleistung unterhalb eines jeweiligen vorgegebenen Schwellwerts liegen und somit weder ein Sende- noch ein Empfangssignal detektiert werden kann, werden ebenfalls der Empfangsverstärkerpfad aktiviert und zusätzlich der Sendeverstärkerpfad deaktiviert.

Gemäß der Erfindung sind der erste und der zweite Frequenzbereich identisch. Ein Beispiel für solche Verfahren sind reine TDD-Verfahren wie z.B. LTE-TDD und TD-SCDMA, bei denen ausschließlich TDD verwendet wird und bei denen Funksignale sowohl in Empfangsrichtung (RX) als auch in Senderichtung (TX) zeitversetzt in demselben Frequenzbereich gesendet werden. Ein weiteres, vorliegend jedoch nicht-beanspruchtes Beispiel sind FDD-Verfahren, bei denen eine Übertragung von Funksignalen zwischen einem Endgerät und einer Antenne in Empfangsrichtung und Senderichtung in unterschiedlichen Frequenzbereichen, d.h. auf unterschiedlichen Trägerfrequenzen, stattfindet.

Gemäß der Erfindung findet die Detektion in Senderichtung (110) und die Detektion in Empfangsrichtung (120) im Wesentlichen gleichzeitig statt. "Im Wesentlichen gleichzeitig" bedeutet hierbei, dass die Detektion in Sende- und Empfangsrichtung auch zeitlich kurz nacheinander stattfinden kann. Entscheidend ist dabei, dass die Detektion in Senderichtung sowie die Detektion in Empfangsrichtung beide in einem Zeitfenster stattfinden, das sicherstellt, dass beispielsweise im Fall eines TDD-Verfahrens noch kein Umschalten von einer Übertragungsrichtung in die andere stattgefunden hat.

In einer weiteren Ausführungsform werden die Funksignale gemäß einem Zeitduplexverfahren (Time Division Duplex, TDD) übertragen. In solchen Verfahren ist eine frequenzselektive Unterscheidung von TX- und RX-Signalen nicht möglich. Das erfindungsgemäße Verfahren erlaubt hingegen eine Richtungserkennung von Funksignalen in bidirektionalen Verstärkersystemen auch für den Fall von TDD-Verfahren.

In einer weiteren Ausführungsform erfolgt die Detektion in Senderichtung mittels eines ersten Auskoppelns eines Anteils der in Senderichtung anliegenden Signalleistung an einem ersten Auskopplungspunkt, und die Detektion in Empfangsrichtung erfolgt mittels eines zweiten Auskoppelns eines Anteils der in Empfangsrichtung anliegenden Signalleistung an einem zweiten Auskopplungspunkt. Die auf diese Weise ausgekoppelten Anteile der Signalleistungen können anderen Elementen der Schaltungsanordnung zur weiteren Verarbeitung zugeleitet werden.

In einer weiteren Ausführungsform erfolgt das erste Auskoppeln mittels eines Endgeräte-seitigen Kopplers, der einem Sendesignalleistungsdetektor vorgeschaltet ist, und das zweite Auskoppeln erfolgt mittels eines Antennen-seitigen Kopplers, der einem Empfangssignalleistungsdetektor vorgeschaltet ist.

In einer weiteren Ausführungsform sind der Sendesignaldetektor und der Empfangssignaldetektor zueinander richtungsentkoppelt. Dies stellt sicher, dass bei einem Sendesignal der Sendesignalleistungsdetektor eine höhere Leistung misst als der Empfangssignalleistungsdetektor, und umgekehrt, dass bei einem Empfangssignal der Empfangssignalleistungsdetektor eine höhere Leistung misst als der Sendesignalleistungsdetektor. Weiterhin ist auf diese Weise sichergestellt, dass bei einem zeitgleichen Anliegen eines Sende- und Empfangssignals die Empfindlichkeit der Sendesignaldetektion hoch ist und somit ein Sendesignal mit einer höheren Empfindlichkeit detektiert wird als ein Empfangssignal. Je höher dabei die Entkopplung bezüglich der Signalrichtung ist, desto geringere Sendesignalpegel können bei gleichzeitigem Anliegen eines Empfangssignals an der Antenneneinheit detektiert werden. Mit anderen Worten wird die Desensibilisierung der Sendesignaldetektion, die durch koexistierende Empfangssignale an der Antenneneinheit bewirkt werden, durch eine möglichst hohe Entkopplung der Detektoren vermindert.

In einer weiteren Ausführungsform funktionieren die dem Sendesignaldetektor und dem Empfangssignaldetektor vorgeschalteten Koppler jeweils als Richtkoppler mit hoher Richtwirkung. Dabei ist sichergestellt, dass nur ein geringer Teil der jeweiligen Signalleistung ausgekoppelt wird, um das eigentliche Nutzsignal nicht unnötig zu dämpfen.

In einer weiteren Ausführungsform wird die Richtungsentkopplung durch eine Signaldämpfung zwischen den Auskopplungspunkten erhöht, um eine noch bessere Entkopplung der Detektoren zu erreichen.

In einer weiteren Ausführungsform ist zwischen dem Endgeräte-seitigen Koppler und dem Sendesignalleistungsdetektor sowie zwischen dem Antennen-seitigen Koppler und dem Empfangssignalleistungsdetektor jeweils mindestens ein Bandpassfilter geschaltet.

In einer weiteren Ausführungsform werden der ausgekoppelte Anteil der in Senderichtung anliegenden Signalleistung dem Sendesignalleistungsdetektor und der ausgekoppelte Anteil der in Empfangsrichtung anliegenden Signalleistung dem Empfangssignalleistungsdetektor zugeleitet. Der Sendesignalleistungsdetektor und der Empfangssignalleistungsdetektor erzeugen basierend auf den ausgekoppelten Anteilen jeweils ein Gleichspannungssignal, das jeweils einer Steuereinheit zugeleitet wird.

In einer weiteren Ausführungsform umfasst das Verfahren weiterhin ein Auswerten der Gleichspannungssignale durch die Steuereinheit. Basierend auf einem Ergebnis des Auswertens erfolgt ein Aktivieren der jeweiligen Sende- und/oder Empfangsverstärkerpfade durch die Steuereinheit. Auf diese Weise wird je nach erkannter Signalrichtung der jeweilige Verstärkerpfad aktiviert.

In einer weiteren Ausführungsform umfasst das Verfahren weiterhin ein Zuführen der Funksignale an eine Frequenzweiche, einen Leistungsteiler oder einen Hochfrequenzschalter, um das zugeführte Funksignal in den Sendeverstärkerpfad oder in den Empfangsverstärkerpfad zu leiten.

In einer weiteren Ausführungsform weist der Sendeverstärkerpfad mindestens einen Sendeverstärker auf, und/oder der Empfangsverstärkerpfad weist mindestens einen Empfangsverstärker auf.

Um das oben genannte Ziel zu erreichen, stellt die vorliegende Erfindung außerdem eine entsprechende Schaltungsanordnung zur Verstärkung von Funksignalen zwischen einem Endgerät und einer Antenne bereit. Die Vorrichtung umfasst Mittel zum Ausführen des oben beschriebenen Verfahrens.

Sowohl die vorstehende allgemeine Beschreibung als auch die detaillierte Beschreibung sind als Beispiel aufzufassen und sollen zur Erläuterung der beanspruchten Erfindung dienen. Weitere Vorteile und Merkmale der Erfindung sind aus der nachstehenden Beschreibung, den Zeichnungen und den Patentansprüchen ersichtlich.

### KURZE BESCHREIBUNG DER ZEICHNUNGEN

Die Merkmale der Erfindung werden in den beiliegenden Ansprüchen näher erläutert. Die Erfindung selbst wird jedoch am besten anhand der nachstehenden detaillierten Beschreibung verständlich, die unter Bezugnahme auf die Zeichnungen eine exemplarische Ausführungsform der Erfindung beschreibt. In den Zeichnungen zeigt:
- Fig. 1: ein Ablaufdiagramm eines Verfahrens zum Betrieb einer Schaltungsanordnung zur Verstärkung von Funksignalen zwischen einem Endgerät und einer Antenne gemäß einer Ausführungsform der Erfindung,
- Fig. 2: eine Schaltungsanordnung zur Verstärkung von Funksignalen zwischen einem Endgerät und einer Antenne gemäß einer Ausführungsform der Erfindung,
- Fig. 3: eine Schaltungsanordnung zur Verstärkung von Funksignalen zwischen einem Endgerät und einer Antenne gemäß einem nicht-beanspruchten Beispiel,

- Fig. 4: eine Schaltungsanordnung zur Verstärkung von Funksignalen zwischen einem Endgerät und einer Antenne gemäß einer weiteren Ausführungsform der Erfindung, und
- Fig. 5: eine Schaltungsanordnung zur Verstärkung von Funksignalen zwischen einem Endgerät und einer Antenne gemäß einer weiteren Ausführungsform der Erfindung.

### DETAILLIERTE BESCHREIBUNG DER ERFINDUNG

Die beigefügten Zeichnungen, der technische Inhalt und die detaillierte Beschreibung beziehen sich auf eine bevorzugte Ausführungsform der Erfindung, was jedoch nicht als Beschränkung des Erfindungsgegenstands aufzufassen ist. Alle gleichwertigen Variationen und Änderungen, die entsprechend den beigefügten Ansprüchen der vorliegenden Erfindung vorgenommen werden, sind durch diese Ansprüche abgedeckt. Im Folgenden wird die Erfindung anhand der Zeichnungen detailliert beschrieben.

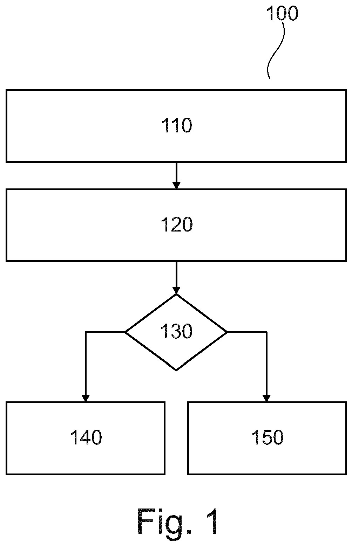

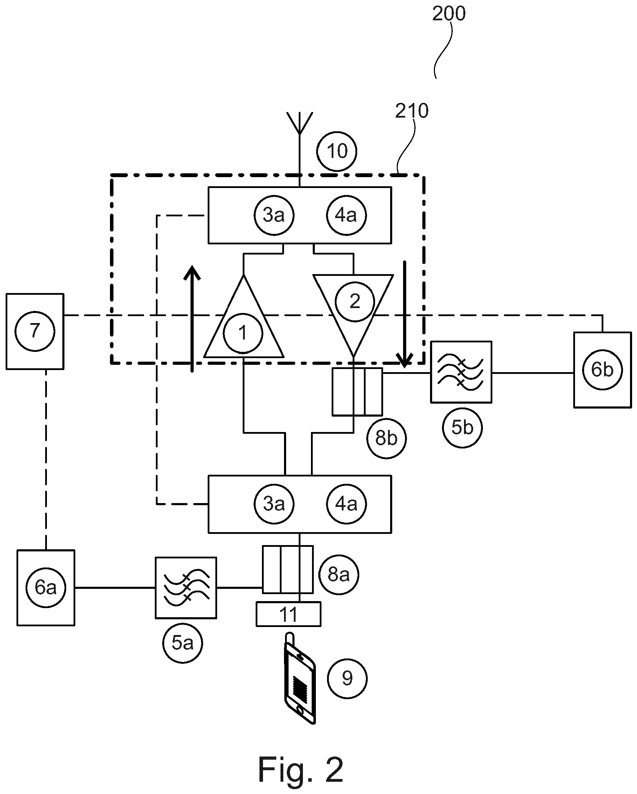

Fig. 1 zeigt ein Ablaufdiagramm eines Verfahrens 100 zum Betrieb einer Schaltungsanordnung 200 zur Verstärkung von Funksignalen zwischen einem Endgerät 9 und einer Antenne 10 gemäß einer Ausführungsform der Erfindung. Die entsprechende Schaltungsanordnung 200 ist in Fig. 2 gezeigt und umfasst eine Verstärkungseinheit 210 mit einem Sendeverstärkerpfad und einem Empfangsverstärkerpfad. Die Schaltungsanordnung 200 wird unten im Detail beschrieben. Das Verfahren 100 umfasst ein Detektieren 110 einer in einem ersten Frequenzbereich anliegenden Signalleistung zur Bestimmung einer Sendesignalleistung. Die Signalleistung liegt dabei aus Sicht des Endgeräts 9 (siehe Fig. 2) in Senderichtung an. Weiterhin umfasst das Verfahren 100 ein Detektieren 120 einer in einem zweiten Frequenzbereich anliegenden Signalleistung zur Bestimmung einer Empfangssignalleistung. Die Empfangssignalleistung liegt dabei aus Sicht des Endgeräts 9 in Empfangsrichtung an.

Wie einführend beschrieben ist das erfindungsgemäße Verfahren so, dass der erste und der zweite Frequenzbereich identisch sind, also die RX- und TX-Nutzfrequenzbereiche identisch sind. Ein Beispiel für solche Verfahren sind reine TDD-Verfahren wie z.B. LTE-TDD und TD-SCDMA, bei denen ausschließlich TDD verwendet wird und bei denen Funksignale sowohl in Empfangsrichtung (RX) als auch in Senderichtung (TX) zeitversetzt in demselben Frequenzbereich erfolgt. Für eine zuverlässige Bestimmung der Richtung von Funksignalen bei Verwendung eines Zeitduplexverfahrens ist es weiterhin vorteilhaft, wenn die Detektion in Senderichtung 110 und die Detektion in Empfangsrichtung 120 im Wesentlichen gleichzeitig stattfindet. Wie oben erläutert bedeutet "im Wesentlichen gleichzeitig" hierbei, dass die Detektion in Sende- und Empfangsrichtung auch zeitlich kurz nacheinander stattfinden kann. Entscheidend ist dabei, dass die Detektion in Senderichtung sowie die Detektion in Empfangsrichtung beide in einem Zeitfenster stattfinden, das sicherstellt, dass beispielsweise im Fall eines TDD-Verfahrens noch kein Umschalten von einer Übertragungsrichtung in die andere stattgefunden hat. Die Detektion in Sende- und Empfangsrichtung muss nicht zeitgleich erfolgen, solange sichergestellt ist, dass die Detektion der Richtung und das entsprechende Umschalten der Verstärkerpfade innerhalb der Einschaltzeit des HF-Signals erfolgt, in der noch keine für die Kommunikation relevanten Informationen enthalten sind. Die zeitgleiche Verarbeitung der Detektoren bietet unter anderem den Vorteil einer schnelleren Verarbeitung von empfangenen und/oder gesendeten Signalen. Weiterhin können mögliche Amplitudenschwankungen der Detektoren durch Modulationen der Signale von beiden Detektoren direkt miteinander verglichen werden.

Anschließend an das Detektieren und Bestimmen 110, 120 der jeweiligen Sende- und Empfangssignalleistung erfolgt ein Vergleichen 130 der detektierten Sendesignalleistung mit der detektierten Empfangssignalleistung. Schritt 130 des Verfahrens 100 stellt eine Fallunterscheidung dar. Falls das Vergleichen 130 ergibt, dass die detektierte Sendesignalleistung stärker ist als die detektierte Empfangssignalleistung, erfolgt ein Aktivieren 140 des Sendeverstärkerpfades zur Verstärkung von Sendesignalen in dem ersten Frequenzbereich in der Schaltungsanordnung 200. Falls hingegen die Empfangssignalleistung stärker ist als die Sendesignalleistung, erfolgt ein Aktivieren 150 des Empfangsverstärkerpfades zur Verstärkung von Empfangssignalen in dem zweiten Frequenzbereich in der Schaltungsanordnung 200. Wie oben ausgeführt, umfasst der Fall, dass die detektierte Empfangssignalleistung stärker ist als die detektierte Sendesignalleistung, auch den Fall, dass kein Sendesignal detektiert werden kann. Falls sowohl die detektierte Sendesignalleistung als auch die detektierte Empfangssignalleistung unterhalb eines jeweiligen vorgegebenen Schwellwerts liegen und somit weder ein Sende- noch ein Empfangssignal detektiert werden kann, wird ebenfalls der Empfangsverstärkerpfad aktiviert, und zusätzlich wird der Sendeverstärkerpfad deaktiviert.

Ergänzend zu dem beschriebenen Vergleichen 130 der detektierten Sendesignalleistung mit der detektierten Empfangssignalleistung kann nach der Detektion eines Sendesignals an dem Sendesignalleistungsdetektor 6a der Empfangspfad in der Schaltungsanordnung unterbrochen bzw. deaktiviert werden, um anschließend über eine wiederholte Signalpegelmessung an dem Sendesignalleistungsdetektor 6a das Vorhandensein eines vom Endgerät 9 ausgehenden Sendesignals zu detektieren. Für den Fall, dass das detektierte Signal ein Antennenseitiges Signal ist, würde nach dem Unterbrechen bzw. Deaktivieren des Empfangspfades kein Signalleistungspegel an dem Sendesignalleistungsdetektor 6a mehr detektiert werden können. Dieses Verfahren hat den Vorteil, dass ein empfangsseitiges Störsignal vom Sendeleistungssignaldetektor 6a ferngehalten werden kann. Dieses Verfahren hat jedoch den Nachteil, dass der Empfangspfad unterbrochen wird und unter Umständen Empfangsnutzsignale nicht verstärkt zum Endgerät weitergeleitet werden.

Für den Fall, dass es sich bei dem Sendesignal um ein TDD-Signal handelt, wird gleichzeitig mit dem Aktivieren des TDD-Sendeverstärkers der TDD-Empfangsverstärkerpfad deaktiviert.

Die Detektion der jeweiligen Signalleistungen in Sende- und Empfangsrichtung 110, 120 erfolgt vorzugsweise mittels eines jeweiligen Auskoppelns eines Anteils der in Senderichtung bzw. Empfangsrichtung anliegenden Signalleistung. Dies erfolgt auf Seiten des Endgeräts 9 mittels eines Endgeräte-seitigen Kopplers 8a als erstem Auskopplungspunkt, der einem Sendesignalleistungsdetektor 6a vorgeschaltet ist. Entsprechend erfolgt das Auskoppeln auf Seiten der Antenne mittels eines Antennen-seitigen Kopplers 8b als zweiten Auskopplungspunkt, der ebenfalls einem Empfangssignalleistungsdetektor 6b vorgeschaltet ist. Die Koppler 8a und 8b können auch an anderen Stellen in der Schaltungsanordnung 200 angeordnet sein, solange der in Empfangsrichtung wirkende Koppler 8a im Empfangspfad und der in Senderichtung wirkende Koppler 8b im Sendepfad liegt. Das heißt, der in Empfangsrichtung wirkende Koppler 8a muss derart angeordnet sein, dass das empfangene Signal über den Koppler 8a läuft und ein Anteil hiervon von diesem auskoppelbar ist, und der in Senderichtung wirkende Koppler 8b muss derart angeordnet sein, dass das gesendete Signal über den Koppler 8b läuft und ein Anteil hiervon von diesem auskoppelbar ist. Insbesondere ist es möglich, einen oder beide der Koppler 8a, 8b auch hinter einem entsprechenden Verstärker zu platzieren.

Um eine zuverlässige Richtungsbestimmung der Funksignale sicherzustellen, sind dabei der Sendesignalleistungsdetektor 6a und der Empfangssignalleistungsdetektor 6b vorzugsweise richtungsentkoppelt zueinander implementiert. Dies wird in vorteilhaften Ausführungsformen beispielsweise dadurch erreicht, dass die dem Sendesignaldetektor 6a und dem Empfangssignaldetektor 6b vorgeschalteten Koppler 8a, 8b jeweils als Richtkoppler mit hoher Richtwirkung ausgestaltet sind.

Anstelle der Verwendung der Richtkoppler 8a, 8b können beispielsweise auch Splitter zur Aufteilung der Sende- und Empfangssignale eingesetzt werden. Auch für Splitter gilt das vorstehend zu den Kopplern 8a, 8b ausgeführte, insbesondere auch hinsichtlich der Anordnung in der Schaltungsanordnung.

Das Aktivieren 140, 150 des jeweiligen Verstärkerpfades, also des Sendeverstärkerpfades oder des Empfangsverstärkerpfades in Abhängigkeit davon, welche der Sendesignalleistung und der Empfangssignalleistung stärker ist (d.h. einen höheren Signalpegel aufweist), wird durch eine Steuereinheit 7 gesteuert. Zu diesem Zweck werden der ausgekoppelte Anteil der in Senderichtung anliegenden Signalleistung dem Sendesignalleistungsdetektor 6a und der ausgekoppelte Anteil der in Empfangsrichtung anliegenden Signalleistung dem Empfangssignalleistungsdetektor 6b zugeleitet. Der Sendesignalleistungsdetektor 6a und der Empfangssignalleistungsdetektor 6b erzeugen basierend auf den ausgekoppelten Anteilen jeweils ein Gleichspannungssignal, das proportional zur jeweiligen Signalleistung ist. Diese Gleichspannungssignale werden der Steuereinheit 7 zugeleitet. Die Steuereinheit 7 wertet die ihr zugeleiteten Gleichspannungssignale aus. Die Auswertung erfolgt vorzugsweise durch eine Berechnungsvorschrift, die beispielsweise durch in der Fertigung der Schaltungsanordnung 200 aufgenommene Kalibrierdaten parametriert wird. Basierend auf einem Ergebnis dieser Auswertung aktiviert die Steuereinheit 7 entsprechend den jeweiligen Sende- und/oder Empfangsverstärkerpfad.

Für den Fall eines erkannten TDD-Sendesignals wird also der TDD-Sendeverstärkerpfad aktiviert; entsprechend wird für den Fall eines erkannten TDD-Empfangssignals zumindest der TDD-Empfangsverstärkerpfad aktiviert, und der TDD-Sendeverstärkerpfad wird deaktiviert.

Ein weiterer Vorteil des erfindungsgemäßen Verfahrens besteht darin, dass das Verfahren sowie die entsprechende Schaltungsanordnung robust gegenüber Signalen sind, die an der Antenneneinheit 10 anliegen können, beispielsweise gegenüber Empfangssignalen, die von einer oder mehreren Basisstationen empfangen werden oder auch gegenüber Sendesignalen von in der Nähe befindlichen sonstigen Endgeräten.

Beispielsweise sendet ein beliebiges sonstiges Endgerät außerhalb eines Fahrzeuges, in dem die erfindungsgemäße Schaltungsanordnung verbaut ist, ein Funksignal, wobei sich das sonstige Endgerät in der Nähe der Antenneneinheit 10 befindet. Das Sendesignal des sonstigen Endgeräts liegt als Störsignal an der Antenneneinheit 10 an. Das erfindungsgemäße Verfahren kann das Störsignal durch die erfindungsgemäße Richtungserkennung erkennen.

In einem anderen Szenario sendet eine Basisstation in E-UTRA-Band 3 (FDD) im Downlink. Der Empfangsfrequenzbereich des E-UTRA-Bandes 3 grenzt an das E-UTRA-Band 39 (TDD) an. Durch die erfindungsgemäße Richtungserkennung kann das störende Basisstationssignal erkannt werden und wird somit insbesondere nicht als ein Sendesignal des Endgeräts 9 in Band 39 detektiert.

In einem weiteren Szenario sendet ein weiteres Endgerät oder eine Basisstation, das bzw. die sich in der Nähe der Antenneneinheit 10 befindet, im E-UTRA-Band 7 (FDD Uplink oder Downlink). Das E-UTRA-Band 7 überschneidet sich mit dem E-UTRA-Band 41 (TDD). Durch die erfindungsgemäße Richtungserkennung wird ein fehlerhaftes Detektieren eines Sendesignals in E-UTRA-Band 41 verhindert.

Zusammenfassend ist es somit möglich, mittels der erfindungsgemäßen Richtungserkennung einen Störer einer Frequenz in anderen (speziell benachbarten) Bändern zu detektieren. Wie oben ausgeführt, ist dies besonders für den Fall dicht aneinandergrenzender oder sich überschneidender Bänder im Frequenzspektrum vorteilhaft.

Fig. 2 zeigt eine Schaltungsanordnung 200 zur Verstärkung von Funksignalen zwischen einem Endgerät 9 und einer Antenne 10, umfassend Mittel zum Ausführen des oben beschriebenen Verfahrens. Fig. 2 zeigt die oben erwähnten Endgeräte- und Antennen-seitigen Koppler 8a, 8b sowie die an die Koppler 8a, 8b gekoppelten Frequenzweichen 3a und Hochfrequenzschalter 4a. Anstelle von oder zusätzlich zu Frequenzweichen oder Hochfrequenzschaltern können Leistungsteiler verwendet werden. Ein vom Endgerät 9 kommendes Sendesignal wird über den Koppler 8a (bzw. einem entsprechenden Splitter) in den Sendeverstärkerpfad zur Antenne 10 geleitet und damit durch den Sendeverstärker 1, während ein von der Antenne 10 kommendes Empfangssignal über den Empfangsverstärkerpfad zum Endgerät 9 geleitet wird und damit durch den Empfangsverstärker 2. Sende- und Empfangsverstärker 1 und 2 sind in Fig. 2 als Verstärkungseinheit 210 zusammengefasst. Zwischen den Kopplern 8a, 8b (bzw. den entsprechenden Splittern) und den entsprechenden Sende- bzw. Empfangssignalleistungsdetektor 6a, 6b ist jeweils ein Hochfrequenzfilter 5a, 5b angeordnet, das zum Filtern der ausgekoppelten Signalanteile entsprechend des zu bestimmenden Frequenzbereiches dient. Die Steuereinheit 7, die zum Steuern (d.h. Aktivieren und Deaktivieren) der Sende- und Empfangsverstärkerpfade eingerichtet ist, ist mit dem Sendesignalleistungsdetektor 6a sowie dem Empfangssignalleistungsdetektor 6b gekoppelt. Das Zuführen der Funksignale, die von dem Endgerät 9 und/oder der Antenne 10 kommen, erfolgt vorzugsweise an eine Frequenzweiche 3, einen Leistungsteiler (Koppler) oder einen Hochfrequenzschalter 4, um auf diese Weise das zugeführte Funksignal in den Sendeverstärkerpfad oder in den Empfangsverstärkerpfad zu leiten. Der Sendeverstärkerpfad weist mindestens einen Sendeverstärker 1 auf, und der Empfangsverstärkerpfad weist entsprechend mindestens einen Empfangsverstärker 2 auf.

Die Schaltungsanordnung 200 nimmt vorzugsweise mit Hilfe einer Übertragungseinheit 11 die Sendesignale des Endgeräts 9 zur leitungsbasierten Weiterverarbeitung mit Hilfe der Schaltungsanordnung 200 auf und überträgt die Empfangssignale der Antenne 10 nach der Weiterverarbeitung durch die Schaltungsanordnung 200 an das Endgerät 9. Die Übertragungseinheit 11 ist jedoch nicht notwendigerweise Teil der Schaltungsanordnung. In Sendesignalrichtung schließt sich an die Übertragungseinheit 11 der Koppler 8a an, der dazu dient, das Sendesignal des Endgeräts 9 in (zumindest) einen ersten Signalteil und einen zweiten Signalteil aufzuteilen und den ersten Signalteil dem Sendesignalleistungsdetektor 6a und den zweiten Signalteil der Verstärkungseinheit 210 zuzuführen.

Wie in Fig. 2 gezeigt, kann der Sendesignalleistungsdetektor 6a Sendesignale aufnehmen, bevor diese einen Sendeleistungsverstärker durchlaufen, während der Empfangssignalleistungsdetektor 6b Empfangssignale aufnimmt, nachdem diese einen Empfangsleistungsverstärker durchlaufen haben. Diese Anordnung kann jedoch in vielerlei Hinsicht geändert werden: Beispielsweise könnte auch dem Sendesignalleistungsdetektor 6a ein Signalverstärker vorgeschaltet sein, oder der Empfangssignalleistungsdetektor 6b könnte Empfangssignale aufnehmen, bevor sie einen Empfangsleistungsverstärker durchlaufen. In letzterem Falle könnte auch dem Empfangssignalleistungsdetektor 6b ein gesonderter Vorverstärker vorgeschaltet sein. Der Vorteil, den Empfangssignalleistungsdetektor 6b erst nach dem Empfangsleistungsverstärker 2, wie in Fig. 2 gezeigt, anzuordnen, ist darin zu sehen, dass auf einen Vorverstärker verzichtet werden kann und der Empfangssignalleistungsdetektor mit geringerer Empfindlichkeit ausgebildet sein kann.

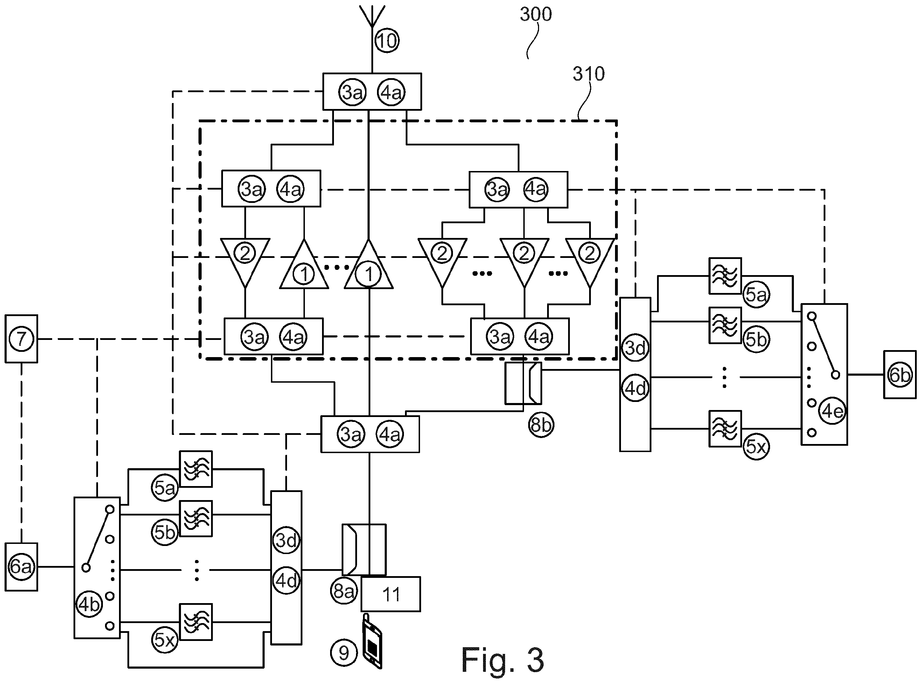

Fig. 3 zeigt eine Schaltungsanordnung 300 zur Verstärkung von Funksignalen zwischen einem Endgerät 9 und einer Antenne 10 gemäß einem nicht-beanspruchten Beispiel. Insbesondere stellt die in Fig. 3 gezeigte Schaltungsanordnung 300 eine Erweiterung der in Fig. 2 gezeigten Schaltungsanordnung 200 auf ein Multi-Band-Verstärkersystem dar.

Aufgrund der Erweiterung auf ein Multi-Band-Verstärkersystem weist die Schaltung 300 entsprechend mehrere Verstärkerpfade auf, die in der Fig. 3 als Verstärkungseinheit 310 zusammengefasst sind. Für jedes von der Schaltungsanordnung 300 zu unterstützende Frequenzband ist dabei jeweils mindestens ein Sendeverstärkerpfad und ein Empfangsverstärkerpfad vorgesehen. Je nachdem, ob in dem jeweiligen Frequenzband ein Halbduplex- oder ein Vollduplex-Verfahren zu unterstützt ist, sind die jeweiligen Sende- und Empfangsverstärkerpfade eines Frequenzbandes gleichzeitig bzw. parallel oder unabhängig voneinander schaltbar (d.h. zu aktivieren/deaktivieren). Anstatt nur eines Hochfrequenzfilters 5a wie in der Schaltungsanordnung 200 der Fig. 2 gezeigt sind in der Schaltungsanordnung 300 der Fig. 3 mehrere Hochfrequenzfilter 5a, 5b, ..., 5x zwischen den Kopplern 8a, 8b und den entsprechenden Sende- bzw. Empfangssignalleistungsdetektoren 6a, 6b angebracht, wobei jedes der Hochfrequenzfilter 5a, 5b, ..., 5x zum Filtern der ausgekoppelten Signalanteile entsprechend der zu bestimmenden Frequenzbereiche dient, die in dem Multi-Band-Verstärkersystem unterstützt werden. Zusätzlich weist die Schaltungsanordnung 300 weitere Frequenzweichen 3c, 3d und/oder weitere Hochfrequenzschalter 4c, 4d auf, die jeweils zwischen den Kopplern 8a, 8b und die mehreren Hochfrequenzfilter 5a, 5b, ..., 5x angeordnet sind und die die ausgekoppelten Sende- und Empfangssignalanteile den Hochfrequenzfiltern 5a, 5b, ..., 5x zuleiten. Zwischen die Sende- und Empfangssignalleistungsdetektoren 6a, 6b ist jeweils ein entsprechender Hochfrequenzschalter 4b, 4e gekoppelt, der das jeweilige von den Hochfrequenzfiltern 5a, 5b, ..., 5x gefilterte Signal den Sende- und Empfangssignalleistungsdetektoren 6a, 6b zuleitet. Dabei werden die Hochfrequenzschalter 4b, 4e vorzugsweise parallel geschaltet (d.h. gleichzeitig in gleicher Weise), um sicherzustellen, dass in beiden Detektoren 6a, 6b jeweils derselbe Frequenzbereich detektiert wird.

Alternativ zu der Verwendung von Hochfrequenzschaltern 4b, 4e ist auch eine Verwendung von Frequenzweichen oder Leistungsteilern denkbar. Dies ist in der Fig. 3 nicht gezeigt.

Die Koppler bzw. Leistungsteiler 8a und 8b können alternativ an anderen Orten in der Schaltungsanordnung 200, 300 angeordnet sein, solange sichergestellt ist, dass sich der Sendesignal-seitige Koppler 8a zumindest im Sendepfad und der Empfangssignalseitige Koppler 8b zumindest im Empfangspfad befinden und beide Detektoren 6a und 6b zueinander richtungsentkoppelt sind. Insbesondere gelten die zu Fig. 2 getroffenen Ausführungen zur Anordnung vor bzw. nach entsprechenden Verstärkern auch für die in Fig. 3 gezeigte Ausführungsform.

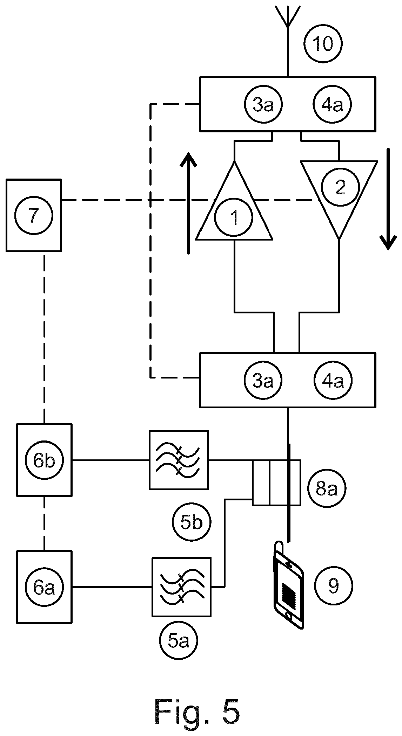

In weiteren Ausführungsformen der Schaltungsanordnung ist nur ein Koppler vorgesehen. Eine entsprechende Schaltungsanordnung ist in der Fig. 5 gezeigt. Dort ist ein Koppler 8a Endgeräte-seitig verbaut. Die zwischen Endgerät 9 und Koppler 8a vorgesehene Übertragungseinheit 11 ist der Übersichtlichkeit halber in Fig. 5 nicht gezeigt. Die Detektorpfade 5a und 5b können alternativ über einen Hochfrequenzschalter an einen einzigen Detektor 6 zusammengeführt werden. In diesem Fall übernimmt der Detektor 6 je nach Stellung des Schalters entweder die Funktion des Sendesignalleistungsdetektors 6a oder in einer weiteren Schalterstellung die Funktion des Empfangssignalleistungsdetektors 6b. Möglich ist es auch, den Koppler antennenseitig anzubringen, beispielsweise in Empfangsrichtung betrachtet vor der/den oben gezeigten Frequenzweiche(n) 3a und dem/den Hochfrequenzschalter(n) 4a.

Auch bei der Schaltungsanordnung 300 wie in Fig. 3 gezeigt ist eine Steuereinheit 7 mit den Sende- und Empfangssignalleistungsdetektoren 6a, 6b gekoppelt, die eingerichtet ist, die ihr zugeleiteten ausgekoppelten Signalanteile auszuwerten und basierend auf einem Ergebnis dieser Auswertung entsprechende Sendeverstärkerpfade und/oder Empfangsverstärkerpfade der Verstärkungseinheit 310 zu steuern (d.h. zu aktivieren/ deaktivieren).

Alternativ oder zusätzlich zu einer Implementierung einer Richtungsentkopplung mittels Richtkopplern, wie oben erläutert, wird eine Richtungsentkopplung in einigen Ausführungsformen dadurch erreicht, dass eine Signaldämpfung zwischen den Auskopplungspunkten (in den oben dargestellten Ausführungsbeispielen sind dies die Koppler 8a, 8b) erhöht wird. Durch das Erhöhen der Richtungsentkopplung der Detektoren 6a, 6b kann eine Desensibilisierung der Sendesignaldetektion am Sendesignalleistungsdetektor 6a, wie sie durch ein gleichzeitiges Störsignal an der Antenneneinheit 10 bewirkt wird, verringert werden.

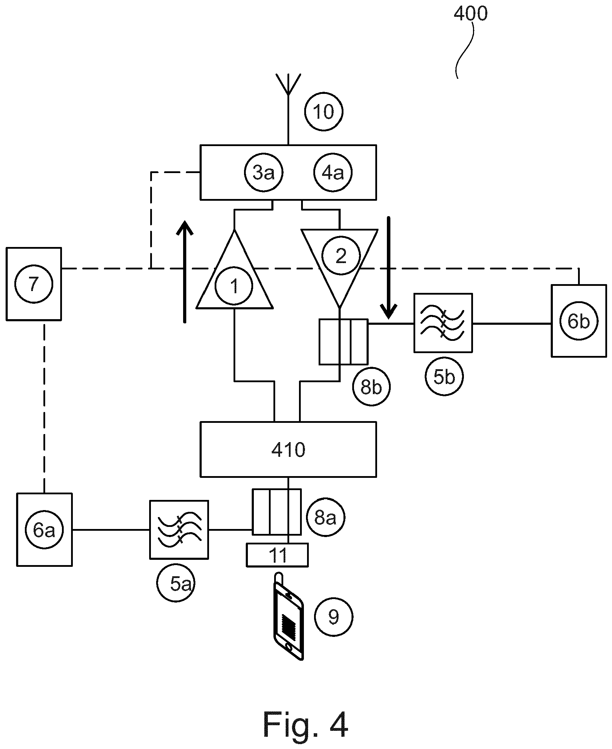

Fig. 4 zeigt eine entsprechende Ausführungsform der Schaltungsanordnung. Die Schaltungsanordnung 400 entspricht dabei im Wesentlichen der Schaltungsanordnung 200 aus Fig. 2. Im Unterschied zur Schaltungsanordnung 200 der Fig. 2 weist die Schaltungsanordnung 400 der Fig. 4 jedoch zusätzlich zu den Endgeräte-seitig angeordneten Frequenzweichen 3a bzw. Hochfrequenzschaltern 4a ein Signaldämpfungselement 410 auf, das die oben erwähnte Signaldämpfung zwischen den Kopplern 8a, 8b erhöht. Das Signaldämpfungselement 410 kann auf verschiedene Weise ausgestaltet sein. Das Signaldämpfungselement 410 kann beispielsweise als eine Kombination aus einem Dämpfungsglied und einem Leistungsteiler (Splitter, Koppler) ausgestaltet sein. Anstelle eines Splitters kann auch ein Schalter in Kombination mit einem Dämpfungsglied verwendet werden. Weitere Kombinationen sind denkbar.

### Bezugszeichenliste

- 1: Sendeverstärker
- 2: Empfangsverstärker
- 3, 3a: Frequenzweiche
- 4, 4a: Hochfrequenzschalter
- 5: Hochfrequenzfilter
- 6a: Sendesignalleistungsdetektor
- 6b: Empfangssignalleistungsdetektor
- 7: Steuereinheit
- 8a, 8b: Koppler
- 9: Endgerät
- 10: Antenne
- 11: Übertragungseinheit
- 100: Verfahren
- 110-150: Verfahrensschritte
- 200, 300, 400: Schaltungsanordnung
- 210: Verstärkungseinheit
- 410: Signaldämpfungselement

## Patentansprüche

1. Verfahren (100) zum Betrieb einer Schaltungsanordnung (200, 300, 400) zur Verstärkung von Funksignalen zwischen einem Endgerät (9) und einer Antenne (10), wobei die Schaltungsanordnung eine Verstärkungseinheit (210, 310) mit mindestens einem Sendeverstärkerpfad und mindestens einem Empfangsverstärkerpfad aufweist, das Verfahren umfassend:
- Detektieren (110) einer in Senderichtung, aus Sicht des Endgeräts (9), in einem ersten Frequenzbereich anliegenden Signalleistung zur Bestimmung einer Sendesignalleistung;
- Detektieren (120) einer in Empfangsrichtung, aus Sicht des Endgeräts (9), in einem zweiten Frequenzbereich anliegenden Signalleistung zur Bestimmung einer Empfangssignalleistung;
- Vergleichen (130) der detektierten Sendesignalleistung mit der detektierten Empfangssignalleistung;
- falls die detektierte Sendesignalleistung stärker ist als die detektierte Empfangssignalleistung, Aktivieren (140) des Sendeverstärkerpfades zur Verstärkung von Sendesignalen in dem ersten Frequenzbereich; und
- falls die detektierte Empfangssignalleistung stärker ist als die detektierte Sendesignalleistung, Aktivieren (150) des Empfangsverstärkerpfades zur Verstärkung von Empfangssignalen in dem zweiten Frequenzbereich;
wobei der erste und der zweite Frequenzbereich, in welchen die Funksignale in Sende-und Empfangsrichtung übertragen werden, identisch sind, und wobei das Detektieren (110) in Senderichtung und das Detektieren (120) in Empfangsrichtung in einem Zeitfenster stattfinden, das sicherstellt, dass nach den Vorgaben des Übertragungsstandards der Funksignale noch kein Umschalten von einer Übertragungsrichtung in die andere Übertragungsrichtung stattgefunden hat.

2. Verfahren nach Anspruch 1, wobei, falls die detektierte Empfangssignalleistung stärker ist als die detektierte Sendesignalleistung, zusätzlich der Sendeverstärkerpfad zur Verstärkung von Sendesignalen in dem ersten Frequenzbereich deaktiviert wird.

3. Verfahren nach einem der vorstehenden Ansprüche, wobei die Funksignale gemäß einem Zeitduplexverfahren (Time Division Duplex, TDD) übertragen werden.

4. Verfahren nach einem der vorstehenden Ansprüche, wobei die Detektion in Senderichtung (110) mittels eines ersten Auskoppelns eines Anteils der in Senderichtung anliegenden Signalleistung an einem ersten Auskopplungspunkt erfolgt, und wobei die Detektion in Empfangsrichtung (120) mittels eines zweiten Auskoppelns eines Anteils der in Empfangsrichtung anliegenden Signalleistung an einem zweiten Auskopplungspunkt erfolgt.

5. Verfahren nach Anspruch 4, wobei das erste Auskoppeln mittels eines Endgeräte-seitigen Kopplers (8a) erfolgt, der einem Sendesignalleistungsdetektor (6a) vorgeschaltet ist, und wobei das zweite Auskoppeln mittels eines Antennen-seitigen Kopplers (8b) erfolgt, der einem Empfangssignalleistungsdetektor (6b) vorgeschaltet ist.

6. Verfahren nach Anspruch 5, wobei der Sendesignalleistungsdetektor (6a) und der Empfangssignalleistungsdetektor (6b) zueinander richtungsentkoppelt sind.

7. Verfahren nach Anspruch 6, wobei die dem Sendesignalleistungsdetektor (6a) und dem Empfangssignalleistungsdetektor (6b) vorgeschalteten Koppler (8a, 8b) jeweils als Richtkoppler mit hoher Richtwirkung funktionieren.

8. Verfahren nach Anspruch 6 oder 7, wobei die Richtungsentkopplung durch eine Signaldämpfung zwischen den Auskopplungspunkten erhöht wird.

9. Verfahren nach einem der Ansprüche 5 bis 8, wobei zwischen dem Endgeräte-seitigen Koppler (8a) und dem Sendesignalleistungsdetektor (6a) sowie zwischen dem Antennen-seitigen Koppler (8b) und dem Empfangssignalleistungsdetektor (6b) jeweils mindestens ein Bandpassfilter geschaltet ist.

10. Verfahren nach einem der Ansprüche 4 bis 9, wobei der ausgekoppelte Anteil der in Senderichtung anliegenden Signalleistung dem Sendesignalleistungsdetektor (6a) und der ausgekoppelte Anteil der in Empfangsrichtung anliegenden Signalleistung dem Empfangssignalleistungsdetektor (6b) zugeleitet werden, und wobei der Sendesignalleistungsdetektor (6a) und der Empfangssignalleistungsdetektor (6b) basierend auf den ausgekoppelten Anteilen jeweils ein Gleichspannungssignal erzeugen, das jeweils einer Steuereinheit (7) zugeleitet wird.

11. Verfahren nach Anspruch 10, wobei das Verfahren weiterhin umfasst:
- Auswerten, durch die Steuereinheit (7), der Gleichspannungssignale;
- basierend auf einem Ergebnis des Auswertens: Aktivieren, durch die Steuereinheit (7), der jeweiligen Sende- und/oder Empfangsverstärkerpfade.

12. Verfahren nach einem der vorstehenden Ansprüche, wobei das Verfahren weiterhin ein Zuführen der Funksignale an eine Frequenzweiche (3), einen Leistungsteiler oder einen Hochfrequenzschalter (4) umfasst, um das zugeführte Funksignal in den Sendeverstärkerpfad oder in den Empfangsverstärkerpfad zu leiten.

13. Verfahren nach einem der vorstehenden Ansprüche, wobei der Sendeverstärkerpfad mindestens einen Sendeverstärker (1) aufweist, und/oder wobei der Empfangsverstärkerpfad mindestens einen Empfangsverstärker (2) aufweist.

14. Schaltungsanordnung (200, 300, 400) zur Verstärkung von Funksignalen zwischen einem Endgerät (9) und einer Antenne (10), umfassend eine Verstärkungseinheit (210, 310) mit mindestens einem Sendeverstärkerpfad und mindestens einem Empfangsverstärkerpfad, und weiterhin umfassend Mittel ausgebildet zum:
- Detektieren (110) einer in Senderichtung, aus Sicht des Endgeräts (9), in einem ersten Frequenzbereich anliegenden Signalleistung zur Bestimmung einer Sendesignalleistung;
- Detektieren (120) einer in Empfangsrichtung, aus Sicht des Endgeräts (9), in einem zweiten Frequenzbereich anliegenden Signalleistung zur Bestimmung einer Empfangssignalleistung;
- Vergleichen (130) der detektierten Sendesignalleistung mit der detektierten Empfangssignalleistung;
- falls die detektierte Sendesignalleistung stärker ist als die detektierte Empfangssignalleistung, Aktivieren (140) des Sendeverstärkerpfades zur Verstärkung von Sendesignalen in dem ersten Frequenzbereich; und
- falls die detektierte Empfangssignalleistung stärker ist als die detektierte Sendesignalleistung, Aktivieren (150) des Empfangsverstärkerpfades zur Verstärkung von Empfangssignalen in dem zweiten Frequenzbereich,
wobei der erste und der zweite Frequenzbereich identisch sind, und
wobei die Schaltungsanordnung so ausgebildet ist, dass das Detektieren (110) in Senderichtung und das Detektieren (120) in Empfangsrichtung in einem Zeitfenster stattfinden, das sicherstellt, dass nach den Vorgaben des Übertragungsstandards der Funksignale noch kein Umschalten von einer Übertragungsrichtung in die andere Übertragungsrichtung stattgefunden hat.

## Claims

1. Method (100) for operating a circuit arrangement (200, 300, 400) for amplifying radio signals between a terminal device (9) and an antenna (10), wherein the circuit arrangement has an amplifying unit (210, 310) having at least one transmission amplifier path and at least one reception amplifier path, the method comprising:
- detecting (110) a signal power in the transmitting direction, from the point of view of the terminal device (9), in a first frequency range in order to determine a transmitted signal power;
- detecting (120) a signal power in the receiving direction, from the point of view of the terminal device (9), in a second frequency range in order to determine a received signal power;
- comparing (130) the detected transmitted signal power to the detected received signal power;
- if the detected transmitted signal power is stronger than the detected received signal power, activating (140) the transmission amplifier path in order to amplify transmitted signals in the first frequency range; and
- if the detected received signal power is stronger than the detected transmitted signal power, activating (150) the reception amplifier path in order to amplify received signals in the second frequency range;
wherein the first and second frequency ranges in which the radio signals are transmitted in the transmitting and receiving direction are identical, and wherein detecting (110) in the transmitting direction and detecting (120) in the receiving direction take place in a time window which ensures that, according to the specifications of the transmission standard of the radio signals, no switching from one transmitting direction to the other transmitting direction has taken place yet.

2. Method according to claim 1, wherein if the detected received signal power is stronger than the detected transmitted signal power, the transmission amplifier path for amplifying transmitted signals in the first frequency range is additionally deactivated.

3. Method according to any of the preceding claims, wherein the radio signals are transmitted according to a time-division duplex (TDD) method.

4. Method according to any of the preceding claims, wherein detecting in the transmitting direction (110) takes place by means of a first coupling out of a portion of the signal power in the transmitting direction at a first coupling-out point and wherein detecting in the receiving direction (120) takes place by means of a second coupling out of a portion of the signal power in the receiving direction at a second coupling-out point.

5. Method according to claim 4, wherein the first coupling out takes place by means of a coupler (8a) on the terminal device side, which is connected upstream of a transmitted signal power detector (6a), and wherein the second coupling out takes place by means of a coupler (8b) on the antenna side, which is connected upstream of a received signal power detector (6b).

6. Method according to claim 5, wherein the transmitted signal power detector (6a) and the received signal power detector (6b) are directionally decoupled from each other.

7. Method according to claim 6, wherein the couplers (8a, 8b) connected upstream of the transmitted signal power detector (6a) and the received signal power detector (6b) each function as directional couplers with high directivity.

8. Method according to claim 6 or 7, wherein the directional decoupling is increased by signal attenuation between the coupling-out points.

9. Method according to any of claims 5 to 8, wherein at least one bandpass filter is connected in each case between the coupler (8a) on the terminal device side and the transmitted signal power detector (6a) as well as between the coupler (8b) on the antenna side and the received signal power detector (6b).

10. Method according to any of claims 4 to 9, wherein the coupled-out portion of the signal power in the transmitting direction is routed to the transmitted signal power detector (6a) and the coupled-out portion of the signal power in the receiving direction is routed to the received signal power detector (6b), and wherein the transmitted signal power detector (6a) and the received signal power detector (6b) each generate, based on the coupled-out portions, a DC voltage signal which is routed to a control unit (7) in each case.

11. Method according to claim 10, wherein the method further comprises:
- evaluating the DC voltage signals by means of the control unit (7);
- based on a result of the evaluation, activating, by means of the control unit (7), the respective transmission and/or reception amplifier paths.

12. Method according to any of the preceding claims, wherein the method further comprises supplying the radio signals to a diplexer (3), a power splitter, or a highfrequency switch (4) in order to route the supplied radio signal into the transmission amplifier path or into the reception amplifier path.

13. Method according to any of the preceding claims, wherein the transmission amplifier path has at least one transmission amplifier (1), and/or wherein the reception amplifier path has at least one reception amplifier (2).

14. Circuit arrangement (200, 300, 400) for amplifying radio signals between a terminal device (9) and an antenna (10), comprising an amplifying unit (210, 310) having at least one transmission amplifier path and at least one reception amplifier path, and further comprising means designed to:
- detect (110) a signal power in the transmitting direction, from the point of view of the terminal device (9), in a first frequency range in order to determine a transmitted signal power;
- detect (120) a signal power in the receiving direction, from the point of view of the terminal device (9), in a second frequency range in order to determine a received signal power;
- compare (130) the detected transmitted signal power to the detected received signal power;
- if the detected transmitted signal power is stronger than the detected received signal power, activate (140) the transmission amplifier path in order to amplify transmitted signals in the first frequency range; and
- if the detected received signal power is stronger than the detected transmitted signal power, activate (150) the reception amplifier path in order to amplify received signals in the second frequency range;
wherein the first and second frequency ranges are identical, and
wherein the circuit arrangement is designed such that detecting (110) in the transmitting direction and detecting (120) in the receiving direction take place in a time window which ensures that, according to the specifications of the transmission standard of the radio signals, no switching from one transmitting direction to the other transmitting direction has taken place yet.

## Revendications

1. Procédé (100) permettant de faire fonctionner un circuit (200, 300, 400) pour amplifier des signaux radio entre un appareil terminal (9) et une antenne (10), dans lequel le circuit présente une unité d'amplification (210, 310) dotée d'au moins un chemin amplificateur d'émission et d'au moins un chemin amplificateur de réception, le procédé comprenant :
- la détection (110) d'une puissance de signal située dans une première plage de fréquences, dans une direction d'émission, vue depuis l'appareil terminal (9), afin de déterminer une puissance de signal d'émission ;
- la détection (120) d'une puissance de signal située dans une seconde plage de fréquences, dans une direction de réception, vue depuis l'appareil terminal (9), afin de déterminer une puissance de signal de réception ;
- la comparaison (130) de la puissance de signal d'émission détectée à la puissance de signal de réception détectée ;
- si la puissance de signal d'émission détectée est plus forte que la puissance de signal de réception détectée, l'activation (140) du chemin amplificateur d'émission pour amplifier des signaux d'émission dans la première plage de fréquences ; et
- si la puissance de signal de réception détectée est plus forte que la puissance de signal d'émission détectée, l'activation (150) du chemin amplificateur de réception pour amplifier des signaux de réception dans la seconde plage de fréquences ;
dans lequel les première et seconde plages de fréquences, dans lesquelles les signaux radio sont transmis dans les directions d'émission et de réception, sont identiques, et
dans lequel la détection (110) dans la direction d'émission et la détection (120) dans la direction de réception ont lieu dans une fenêtre de temps, qui veille à ce que d'après les spécifications de la norme de transmission des signaux radio aucune commutation d'une direction de transmission n'ait encore eu lieu dans l'autre direction de transmission.

2. Procédé selon la revendication 1, dans lequel, si la puissance de signal de réception détectée est plus forte que la puissance de signal d'émission détectée, le chemin amplificateur d'émission pour amplifier des signaux d'émission est désactivé en outre dans la première plage de fréquences.

3. Procédé selon l'une quelconque des revendications précédentes, dans lequel les signaux radio sont transmis selon un procédé duplex temporel (Time Division Duplex, TDD).

4. Procédé selon l'une quelconque des revendications précédentes, dans lequel la détection dans la direction d'émission (110) s'effectue au moyen d'un premier découplage d'une partie de la puissance de signal située dans la direction d'émission au niveau d'un premier point de découplage, et dans lequel la détection dans la direction de réception (120) s'effectue au moyen d'un second découplage d'une partie de la puissance de signal située dans la direction de réception au niveau d'un second point de découplage.

5. Procédé selon la revendication 4, dans lequel le premier découplage s'effectue au moyen d'un coupleur côté appareil terminal (8a), qui est monté en amont d'un détecteur de puissance de signal d'émission (6a), et dans lequel le second découplage s'effectue au moyen d'un coupleur côté antenne (8b), qui est monté en amont d'un détecteur de puissance de signal de réception (6b).

6. Procédé selon la revendication 5, dans lequel le détecteur de puissance de signal d'émission (6a) et le détecteur de puissance de signal de réception (6b) sont découplés directionnellement l'un de l'autre.

7. Procédé selon la revendication 6, dans lequel le coupleur (8a, 8b) monté en amont du détecteur de puissance de signal d'émission (6a) et du détecteur de puissance de signal de réception (6b) fonctionnent respectivement en tant que coupleur directionnel à haute directivité.

8. Procédé selon la revendication 6 ou 7, dans lequel le découplage directionnel est augmenté par un affaiblissement du signal entre les points de découplage.

9. Procédé selon l'une quelconque des revendications 5 à 8, dans lequel au moins un filtre passe-bande est monté respectivement entre le coupleur côté appareil terminal (8a) et le détecteur de puissance de signal d'émission (6a), ainsi qu'entre le coupleur côté antenne (8b) et le détecteur de puissance de signal de réception (6b).

10. Procédé selon l'une quelconque des revendications 4 à 9, dans lequel la partie découplée de la puissance de signal située dans la direction d'émission est transmise au détecteur de puissance de signal d'émission (6a) et la partie découplée de la puissance de signal située dans la direction de réception est transmise au détecteur de puissance de signal de réception (6b), et dans lequel le détecteur de puissance de signal d'émission (6a) et le détecteur de puissance de signal de réception (6b) sur la base des parties découplées produisent respectivement un signal de tension continue, qui est respectivement transmis à une unité de commande (7).

11. Procédé selon la revendication 10, dans lequel le procédé comprend en outre :
- l'évaluation, par l'unité de commande (7), des signaux de tension continue ;
- sur la base d'un résultat de l'évaluation : l'activation, par l'unité de commande (7), des chemins amplificateurs d'émission et/ou de réception respectifs.

12. Procédé selon l'une quelconque des revendications précédentes, dans lequel le procédé comprend en outre la fourniture des signaux radio à un circuit diviseur de fréquences (3), un diviseur de puissance ou un commutateur haute fréquence (4), pour diriger le signal radio fourni dans le chemin amplificateur d'émission ou dans le chemin amplificateur de réception.

13. Procédé selon l'une quelconque des revendications précédentes, dans lequel le chemin amplificateur d'émission présente au moins un amplificateur d'émission (1), et/ou dans lequel le chemin amplificateur de réception présente au moins un amplificateur de réception (2).

14. Circuit (200, 300, 400) pour amplifier des signaux radio entre un appareil terminal (9) et une antenne (10), comprenant une unité d'amplification (210, 310) dotée d'au moins un chemin amplificateur d'émission et d'au moins un chemin amplificateur de réception, et comprenant en outre un moyen conçu pour :
- détecter (110) une puissance de signal située dans une première plage de fréquences, dans une direction d'émission, vue depuis l'appareil terminal (9), afin de déterminer une puissance de signal d'émission ;
- détecter (120) une puissance de signal, située dans une seconde plage de fréquences, dans une direction de réception, vue depuis l'appareil terminal (9), afin de déterminer une puissance de signal de réception ;
- comparer (130) la puissance de signal d'émission détectée à la puissance de signal de réception détectée ;
- si la puissance de signal d'émission détectée est plus forte que la puissance de signal de réception détectée, activer (140) le chemin amplificateur d'émission pour amplifier des signaux d'émission dans la première plage de fréquences ; et
- si la puissance de signal de réception détectée est plus forte que la puissance de signal d'émission détectée, activer (150) le chemin amplificateur de réception pour amplifier des signaux de réception dans la seconde plage de fréquences ;
dans lequel les première et seconde plages de fréquences sont identiques, et
dans lequel le circuit est conçu de telle sorte que la détection (110) dans la direction d'émission et la détection (120) dans la direction de réception ont lieu dans une fenêtre de temps, qui veille à ce que d'après les spécifications de la norme de transmission des signaux radio aucune commutation d'une direction de transmission n'ait encore eu lieu dans l'autre direction de transmission.
